# EUROPEAN PATENT APPLICATION

(11) **EP 4 657 804 A1**
(43) Date of publication of application: **03.12.2025**
(21) Application number: 25177615.9
(22) Date of filing: 20.05.2025
(51) Int. Cl.: H04L 12/40, H04L 41/0806, H04L 61/5038

(54) **CONTROLLER AREA NETWORK SYSTEM WITH IN-SYSTEM CONFIGURATION**

(30) Priority: 31.05.2024 US 202418680111
(71) Applicant: NXP B.V., 5656 AG Eindhoven (NL)
(72) Inventor: Wu, Kai, 5656AG Eindhoven (NL)
(74) Representative: Miles, John Richard

(57) **Abstract**

A controller area network (CAN) system including a serial conductor (S) bus, a CAN bus, at least one configurable CAN device, and a leader device. Each configurable CAN device is inserted on the S bus and includes media access control (MAC) circuitry and physical medium circuitry. The physical medium circuitry forwards test clocks from the CAN bus to clock internal latches when the CAN bus is in a common mode and interfaces the MAC circuitry for programming via the CAN bus when the CAN bus is in a differential mode. The leader device drives the S bus between first and second logic states, switches the CAN bus between the common and differential modes, generates test clocks on the CAN bus to place a selected configurable CAN device in programming mode, and programs the selected configurable CAN device via the CAN bus.

## Description

### BACKGROUND

### FIELD

The present disclosure relates in controller area networks, and more particularly to a controller area network system with in-system configuration.

### DESCRIPTION OF THE RELATED ART

A controller area network (CAN) is a network that uses a serial communication bus designed for reliable and flexible high-speed in-vehicle communications for industrial and automotive applications. In conventional configurations, CAN devices must be programmed with unique identifiers and identifier (ID) masks during the assembly process. This was because bus access conflicts need to be resolved by content-based arbitration using their identifiers when two or more CAN devices start to transmit data frames or remote frames at the same time. Conventional configurations tended to irrevocably assign the devices' IDs, which meant complex and costly logistics for manufacturers, particularly when revising or updating a configuration. Furthermore, the CAN device identifiers had no accurate or permanent location information of network nodes when the location of a node was changed.

### BRIEF DESCRIPTION OF THE DRAWINGS

Embodiments of the present invention are illustrated by way of example and are not limited by the accompanying figures. Similar references in the figures may indicate similar elements. Elements in the figures are illustrated for simplicity and clarity and have not necessarily been drawn to scale.
FIG. 1 is a simplified block diagram of a controller area network (CAN) system with in-system configuration according to one embodiment.
FIG. 2 is a simplified block diagram of the physical medium circuit of FIG. 1 implemented according to one embodiment which may be used as either one or both of the physical medium devices of the configurable CAN devices of FIG. 1.
FIG. 3 is a figurative timing and state diagram illustrating operation of the leader device of FIG. 1 using the S bus to program the configurable CAN devices coupled to the S bus of FIG. 1 according to one embodiment.
FIG. 4 is a flowchart diagram illustrating operation of the leader device for programming configurable CAN devices inserted onto the S bus of FIG. 1 according to one embodiment.

### DETAILED DESCRIPTION

A controller area network (CAN) system including a serial conductor (S) bus, a CAN bus, at least one configurable CAN device, and a leader device. Each configurable CAN device includes media access control (MAC) circuitry and physical medium circuitry, which may include multiple latches. Each configurable CAN device may be inserted on the S bus effectively placing its internal latches in series on the S bus and in series with the latches of other configurable CAN devices inserted on the S bus. The physical medium circuitry of each configurable CAN device is configured to forward test clocks from the CAN bus to clock each of the latches when the CAN bus is in a common mode and to interface the MAC circuitry for programming via the CAN bus when the CAN bus is in a differential mode. The leader device is configured to drive the S bus between first and second logic states, to switch the CAN bus between the common and differential modes, to generate test clocks on the CAN bus to place a selected configurable CAN device in programming mode, and to program the selected configurable CAN device via the CAN bus.

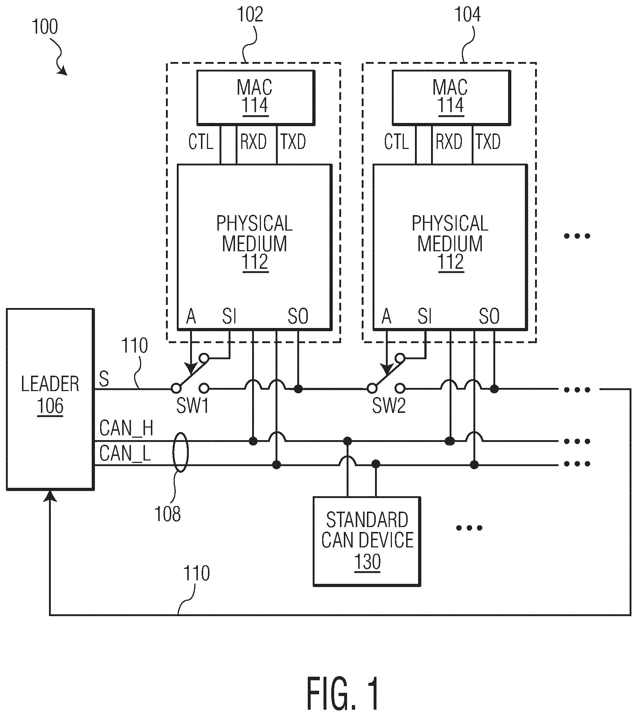

FIG. 1 is a simplified block diagram of a controller area network (CAN) system 100 with in-system configuration according to one embodiment. The CAN system 100 includes a first configurable CAN device 102, a second configurable CAN device 104, and a leader device 106 coupled to a serial CAN bus 108 and a serial conductor (S) bus 110. The CAN bus 108 includes a "high" CAN conductor carrying a CAN signal CAN_H and a "low" CAN conductor carrying a CAN signal CAN_L. Although only two configurable CAN devices 102 and 104 are shown, it is understood that any number of configurable CAN devices may be included in different configurations. The S bus 110 may be equipped with a series of insertion switches for selectively coupling up to a corresponding number of configurable CAN devices to the S bus 110. As shown, a first insertion switch SW1 is controlled for selectively coupling the configurable CAN device 102 and a second insertion switch SW2 is controlled for selectively coupling the configurable CAN device 104. Although only two insertion switches are shown, it is understood that the S bus 110 may include any number of insertion switches, each for coupling the S bus 110 to a corresponding one of multiple configurable CAN devices. Whereas the CAN bus 108 is sufficiently terminated, the S bus 110 forms a loop back to the leader 106. As shown, a last segment of the S bus 110 is provided to a corresponding input of the leader 106.

Each of the insertion switches SW1 and SW2 may be configured as a single-pole, double-throw (SPDT) switch having a control terminal and a first switched terminal coupled to the S bus and a second switched terminal for selectively coupling to a corresponding configurable CAN device. Each of the insertion switches on the S bus 110, including the insertion switches SW1 and SW2, has a default "closed" position in which the control terminal is coupled to the first terminal to bypass a CAN device and an "open" position in which the control terminal is coupled to the second terminal to connect a configurable CAN device as further described herein. Any number of "standard" CAN devices may be included and coupled to the CAN bus 108. As shown, for example, a standard CAN device 130 is coupled to the CAN bus 108 but is not coupled to the S bus 110.

Each configurable CAN device, including the configurable CAN devices 102 and 104, includes a physical medium circuit 112 and a media access control (MAC) circuit 114 that communicate via control (CTL), receive (RXD) and transmit (TXD) signals. The physical medium circuit 112 includes an activation (A) output, an S bus input SI, and an S bus output SO. The SO output of each configurable CAN device, including the configurable CAN devices 102 and 104, is coupled to the S bus 110. The activation output opens a corresponding insertion switch on the S bus 110 to selectively couple the configurable CAN device to the S bus 110. When each insertion switch is closed, it maintains conductive continuity of the S bus 110 to the next insertion switch or back to the S bus input of the leader device 106. As shown, the activation output of the configurable CAN device 102 opens the insertion switch SW1 to connect the SI input of the physical medium circuit 112 of the configurable CAN device 102 to the S bus 110, and the activation output of the configurable CAN device 104 opens the insertion switch SW2 to connect the SI input of the physical medium circuit 112 of the configurable CAN device 104 to the S bus 110. In this manner, the physical medium circuit 112 of each of the configurable CAN devices 102 and 104 are effectively placed in series with the S bus 110 via the SI inputs and SO outputs.

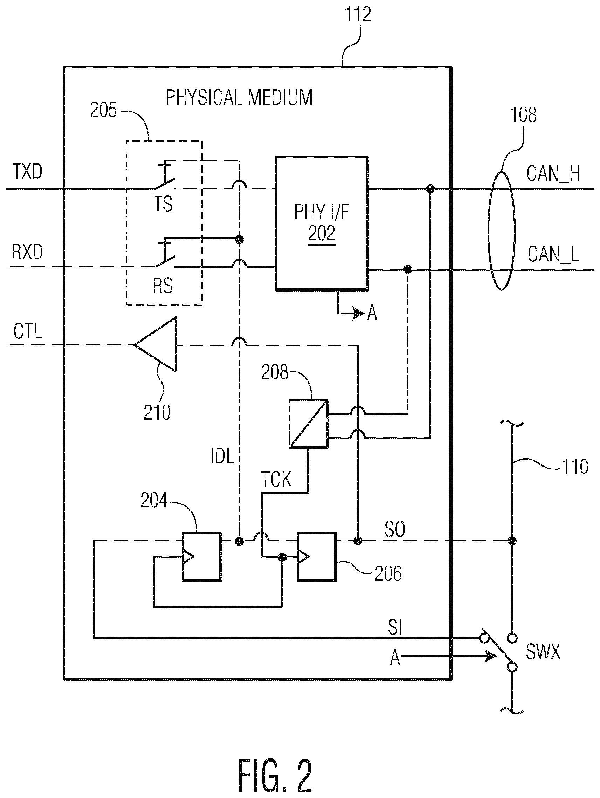

FIG. 2 is a simplified block diagram of the physical medium circuit 112 implemented according to one embodiment which may be used as either one or both of the physical medium devices 112 of the configurable CAN devices 102 and 104. The physical medium circuit 112 includes a physical interface (PHY I/F) 202 that performs the primary physical functions for interfacing the CAN_H/CAN_L signals of the CAN bus 108 and the TXD and RXD signals. Such primary functions are not further described as known. The PHY I/F 202 is also tasked for asserting the activation signal A to an insertion switch SWX on the S bus 110 for effectively placing the physical medium circuit 112 in series with other configurable CAN devices coupled to the S bus 110. The insertion switch SWX is configured in the same manner as the insertion switches SW1 and SW2 previously described. When the insertion switch SWX is opened by A, the SI input of the physical medium circuit 112 is provided to the data input of a first latch 204 of a series of latches up to a last latch 206, having an output providing the SO output of the physical medium circuit 112. In one embodiment, each of the series of latches, including the latches 204 and 206, may be configured as a D-type flip-flop.

A CAN mode sensor 208 is coupled to the CAN bus 108 and configured to detect the operating mode of the CAN bus 108. The operating mode of the CAN bus 108 is either a differential (DIF) mode (for programming or normal operating modes) or a single-ended or common (COM) mode for serially clocking signals through the S bus 110 as further described herein. When the CAN mode sensor 208 detects that the CAN bus 108 is in the COM mode, transitions on (or toggling of) the CAN bus 108 generates test clocks that are provided via a test clock signal TCK to the clock input of each of the series of latches including the latch 204 and the latch 206. When the CAN mode sensor 208 detects that the CAN bus 108 is in the DIF mode, the CAN mode sensor 208 isolates the TCK signal from the CAN bus 108 to avoid clocking the series of latches. Although only two latches are shown and described, it is understood that the series of latches may include more than 2 latches, meaning one or more additional latches (not shown) between the latch 204 and the latch 206.

The output of the first latch 204 asserts an idle (IDL) mode signal which is also provided to control inputs of a pair of single-pole, single-throw (SPST) switches TS and RS of a connection interface 205. The TS switch is in series with the transmit signal TXD provided by the PHY I/F 202 and the RS switch is in series with the receive signal RXD received by the PHY I/F 202 from a corresponding MAC device (e.g., MAC circuit 114). When the IDL signal is asserted low, the TS and RS switches are closed for a programming mode or a normal mode in which the PHY I/F 202 may communicate with a corresponding MAC device. When the IDL signal is asserted high, the TS and RS switches are opened for a corresponding forced idle mode as further described herein.

The output of the SFF 206 provides the SO output of the physical medium circuit 112, which is coupled to the S bus 110 as previously described. The SO output is also provided to an input of a buffer 210, having an output providing the CTL signal to a corresponding MAC device (e.g., MAC circuit 114). The CTL signal may be used as a flag signal indicating the status or mode of the physical medium circuit 112 to the MAC circuit 114 and other higher level functions. The programming mode occurs when the IDL signal is low while the SO signal is high, in which the leader device 106 may switch the CAN bus 108 into the DIF mode and program the configurable CAN device with a unique identifier (ID) and corresponding ID mask or the like. The MAC circuit 114 and other higher level functions detect that CTL is high so that signaling on the CAN bus 108 is used only for programming the configurable CAN device and not used for other CAN functions. The idle mode occurs when the IDL signal is high regardless of the state of the SO (and CTL) signal since the PHY I/F 202 is decoupled from the MAC circuit 114. The normal mode occurs when the IDL and SO signals are both asserted low.

Referring back to FIG. 1, the serial conductor or S bus 110 forms a loop having a first end coupled to an S bus output of the leader device 106 and has a second end coupled to an S bus input of the leader device 106. Each configurable CAN device inserted onto the S bus 110 (via a corresponding activation signal opening a corresponding insertion switch) effectively places its internal series of latches in series on the S bus 110 and thus in series with the internal series of latches of other configurable CAN devices inserted onto the S bus 110, which effectively segments the S bus 110 between the inserted configurable CAN devices and between individual latches within each configurable CAN device. The leader device 106 drives its S bus output to one of two logic states including logic '1' or logic '0' and toggles the CAN bus 108 in COM mode to generate test clocks on the TCK signal that are forwarded via the CAN mode sensor 208 (FIG. 2) of each configurable CAN device to clock each of the latches inserted on the S bus 110. In this manner, each logic state asserted by the leader device 106 is propagated along the S bus 110 via each of the segments of the S bus 110 by the series of latches with each test clock cycle. It is noted that when the leader device 106 places the CAN bus 108 in DIF mode, the CAN mode sensor 208 does not pass any test clocks to the internal latches.

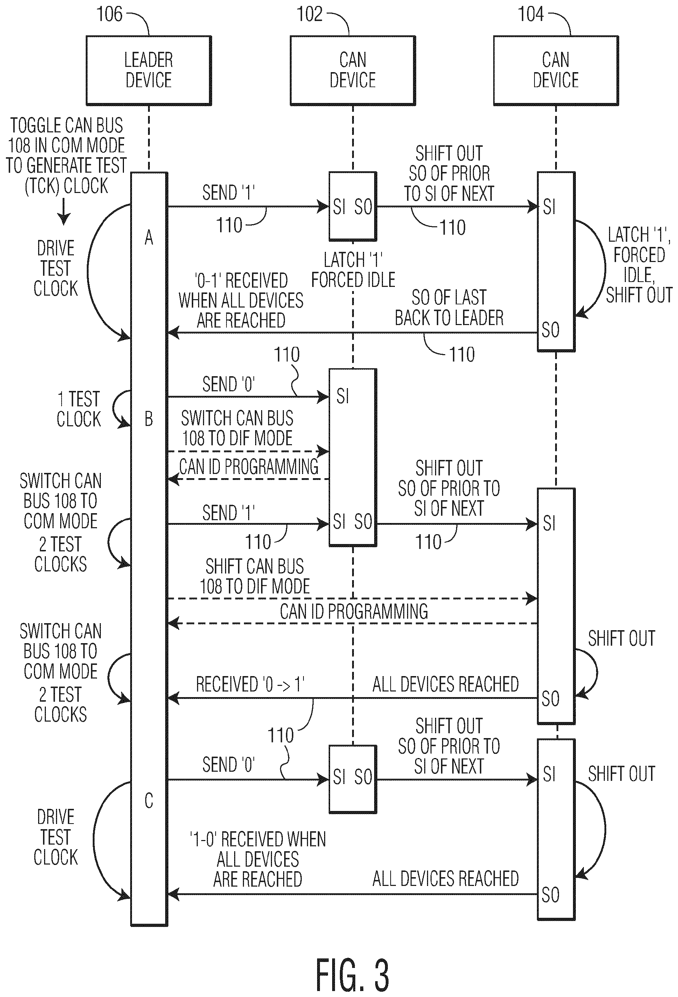

FIG. 3 is a figurative timing and state diagram illustrating operation of the leader device 106 using the S bus 110 to program the configurable CAN devices 102 and 104 coupled to the S bus 110 according to one embodiment. Although only two configurable CAN devices 102 and 104 are shown being programmed, any number of configurable CAN devices coupled to the S bus 110 may be programmed by the leader 106. A dashed line and corresponding boxes below each of the configurable CAN devices 102 and 104 illustrate the state of the configurable CAN device in sequential steps as further described herein. Upon initialization or power-up or reset (POR), each of the latches provided within the physical medium devices 112, including the latches 204 and 206 (and any other latches included therebetween) are reset so that their outputs are reset to a logic '0'. In the illustrated embodiment, it is assumed for simplicity of illustration that each physical medium circuit 112 includes only 2 latches in series as shown in FIG. 2. The leader device 106 may alternatively (or in addition) drive a reset signal (not shown) to reset each of the configurable CAN devices 102 and 104 including their internal latches. In this manner, the entire S bus 110 is initially driven to a logic '0'.

After initialization or POR, the leader 106 performs a first step A by placing the CAN bus 108 in COM mode, asserting a logic '1' on the S bus 110, and toggling the CAN bus 108 to generate sequential test clocks on the TCK signal. When the CAN bus 108 is in the COM mode, the CAN mode sensor 208 toggles the TCK signal in response to toggling of the CAN bus 108 essentially forwarding test clocks to the latches. In this manner, each of the latches within each of the physical medium devices 112 of each of the configurable CAN devices 102 and 104 are clocked in sequential test clock cycles. Thus, during step A a logic '1' is clocked to the output of the latch 204 in the first clock cycle and then to the SO output (via the latch 206) in the second clock cycle of the first configurable CAN device 102, and then to the output of the latch 204 in the third clock cycle and then to the SO output (via the latch 206) in the fourth clock cycle of the second configurable CAN device 104, and so on for as many configurable CAN devices are coupled to the S bus 110. In each case, the SO output of the prior configurable CAN device is shifted into the SI input of the next configurable CAN device in the serial chain of configurable CAN devices. Eventually, the SO output of the last configurable CAN device in the chain, such as the configurable CAN device 104 in the illustrated configuration, is output back to the S bus input of the leader 106. When the S bus input of the leader 106 transitions from logic '0' to logic '1', then the entire S bus 110 has been transitioned to logic '1'.

In addition, the IDL signal at the output of the first latch 204 of each physical medium circuit 112 of each of the configurable CAN devices is asserted to a logic '1' placing each of the configurable CAN devices in the forced idle mode for step A. In the forced idle mode, the TS and RS switches are opened so that the physical medium devices 112 are disconnected from the corresponding MAC circuit 114 for each configurable CAN device.

After step A is completed, the leader 106 performs second step B for programming one or more up to all of the configurable CAN devices on the S bus 110. First, the leader 106 asserts a logic '0' on the S bus 110 and generates 1 test clock to clock the '0' into the first configurable CAN device 102, and then asserts a logic '1' on the S bus 110. The next part of step B depends on which of the configurable CAN devices are to be programmed. Assuming, for example, that the first configurable CAN device 102 is to be programmed, the IDL signal of the physical medium circuit 112 of the configurable CAN device 102 is now logic '0' (while SO and thus CTL is high) and thus in a programming mode. In particular, the IDL signal closes both TS and RS switches so that the PHY I/F 202 is coupled to the MAC circuit 114. The leader 106 then switches the CAN bus 108 to the DIF mode and communicates with the configurable CAN device 102 via the CAN bus 108 to program a device ID shown as CAN ID programming. The PHY I/F 202 of the physical medium circuit 112 transfers the device ID to the corresponding MAC circuit 114, which may be acknowledged via RXD.

Once the first configurable CAN device 102 has been programmed, the leader 106 switches the CAN bus 108 back to the COM mode, asserts a logic '1' on the S bus 110, and generates as many test clock cycles on the CAN bus 108 to move the logic '0' from the first configurable CAN device 102 to the next configurable CAN device to be programmed. Assuming each configurable CAN device has only 2 latches and that the second configurable CAN device 104 is to be programmed, the leader 106 generates 2 test clocks while keeping its S bus output to logic '1' to shift the logic '0' into the first latch 204 of the second configurable CAN device 104. In this manner, the first configurable CAN device 102 is placed back into the forced idle mode while the second configurable CAN device 104 is placed into the programming mode. The leader 106 then switches the CAN bus 108 to the DIF mode again and communicates with the configurable CAN device 104 via the CAN bus 108 to program a different device ID into the configurable CAN device 104 in a similar manner as described for the first configurable CAN device 102.

Again, after the second configurable CAN device 104 has been programmed, the leader 106 switches the CAN bus 108 back to the COM mode, maintains a logic '1' on the S bus 110, and generates as many test clock cycles on the CAN bus 108 to move the logic '0' from the second configurable CAN device 104 to the next configurable CAN device to be programmed. In the simple case illustrated, when the second configurable CAN device 104 is the last to be programmed, the logic '0' is shifted out of the SO output of the second configurable CAN device 104 and loops back to the leader 106 which detects a logic '0 -1' transition. This transition informs the leader 106 that all of the configurable CAN devices to be programmed have been programmed.

As described above, the leader 106 first drives the entire S bus 110 to logic '1' to place all of the configurable CAN devices in forced idle mode in step A, then asserts its S bus output to logic '0' for one test clock to begin step B, and then asserts its S bus output to logic '1' for subsequent test clocks during the programming step B. The leader 106 may program each of the configurable CAN devices one at a time in this manner. It is noted however, that the leader 106 may also target any one or more of the configurable CAN devices for programming while skipping others. For example, the leader 106 may assert multiple test clocks to shift the logic '0' through the first configurable CAN device 102 without programming and into the second configurable CAN device 104 for programming. In the general case, the leader 106 may target any one up to all of the configurable CAN devices by shifting the logic '0' only into those CAN devices targeted for programming.

After each of the configurable CAN devices to be programmed have been programmed, the leader device 106 switches the CAN bus 108 to COM mode, keeps asserting logic '1' at its S bus output, and generates additional test clocks on the CAN bus 108 until a logic '0 - 1' transition is received. This effectively places all of the configurable CAN devices back into idle mode after programming to complete the programming step B.

After the programming step B is completed, the leader 106 performs third step C for transitioning all of the configurable CAN devices on the S bus 110 to normal mode for normal operation. In this case, the leader 106 asserts and keeps a logic '0' on its S bus output and asserts test clocks on the CAN bus 108 until a logic '1 - 0' transition is detected on its S bus input. In this manner, the entire S bus 110 is transitioned back to logic '0' so that all of the configurable CAN devices on the S bus 110 have been transitioned back to the normal mode to being normal operation.

In an alternative configuration, after the last configurable CAN device has been programmed in step B and after switching the CAN bus 108 back to COM mode, rather than clocking logic 1's until a logic '0 - 1' transition is received, step C may be immediately commenced. Instead, the leader 106 asserts and keeps a logic '0' on its S bus output and asserts test clocks on the CAN bus 108 until multiple logic 0's are received to ensure that each of the configurable CAN devices on the S bus 110 have been returned to normal mode.

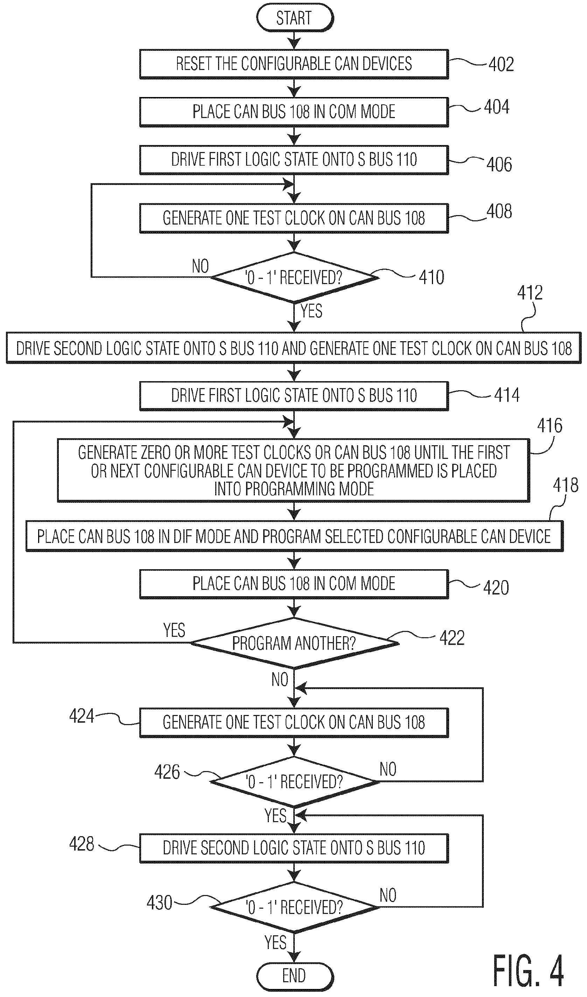

FIG. 4 is a flowchart diagram illustrating operation of the leader device 106 for programming configurable CAN devices inserted onto the S bus 110 according to one embodiment. At a first block 402, the configurable CAN devices may be reset including resetting each of the internal latches. In this manner, each segment of the S bus 110 is asserted to a second logic state (e.g., logic '0') for normal operation. This block may be skipped after POR as previously described when POR automatically resets the latches and devices.

At next block 404, the leader device 106 places the CAN bus 108 into COM mode. At next block 406, the leader device 106 drives the first logic state (e.g., logic '1') onto the S bus 110 via its S bus output. At next block 408, the leader device 106 generates one test clock on the CAN bus 108 and at next block 410 determines whether a '0 - 1' transition is received at its S bus input. If not, operation loops back to block 408 to generate another test clock on the CAN bus 108. The blocks 408 and 410 are repeated as often as necessary until the '0 - 1' transition is received at the S bus input of the leader device 106.

When the '0 - 1' transition is received by the leader device 106, meaning that step A has been completed (with reference to FIG. 2), operation advances to block 412 in which the leader device 106 drives the second logic state (e.g., logic '0') onto the S bus 110 and generates one test clock on the CAN bus 108 to begin step B. This effectively latches the second logic state into the first latch of the first configurable CAN device on the S bus 110 (e.g., the configurable CAN device 102). It is noted that, depending upon the latch configuration of the configurable CAN devices (e.g., the number and configuration of the latches), this may place the first configurable CAN device into the programming mode. At next block 414, the leader device 106 drives the first logic state onto the S bus 110. Then at next block 416, the leader device 106 generates zero or more test clocks on the CAN bus 108 until the first (or next) configurable CAN device to be programmed is placed into the programming mode.

It is noted that at block 416, if the first configurable CAN device is to be programmed and is already in the programming mode, then zero test clocks are needed in the first iteration. Alternatively, if the first configurable CAN device is to be programmed but is not yet in the programming mode (e.g., the mode signal is output from an intermediate latch), then one or more test clocks may be needed to place the first configurable CAN device into the programming mode. On the other hand, if the first configurable CAN device on the S bus 110 is not to be programmed (e.g., skipped), then the leader device 106 generates one or more test clocks on the CAN bus 108 until the next configurable CAN device that is to be programmed is placed into its programming mode. In this manner, the leader device 106 has complete flexibility in selecting from among multiple configurable CAN devices to be programmed.

Once a configurable CAN device has been selected for programming and is in its programming mode, operation advances to block 418 in which the leader device 106 places the CAN bus 108 in DIF mode and programs the selected configurable CAN device. Operation then advances to block 420 in which the leader device 106 places the CAN bus 108 back into the COM mode. Operation advances to block 422 in which the leader device 106 determines whether another one of the configurable CAN devices on the S bus 110 is to be programmed. If so, operation loops back to block 416 in which the leader device 106 generates additional test clocks on the CAN bus 108 until the next configurable CAN device is placed into its programming mode. Blocks 416 to 422 are repeated as often as necessary to program each of the configurable CAN devices to be programmed.

When the leader device 106 determines that there are no more configurable CAN devices to be programmed at block 422, operation advances instead to block 424 and 426 in which one or more test clocks are generated on the CAN bus 108 until a logic '0 - 1' transition is received at the S bus input of the leader device 106. Once the logic '0 - 1' transition is received, programming step B is completed and operation advances to block 428 to begin step C of the programming process. At block 428, the leader device 106 drives the second logic state onto the S bus 110 and then advances to block 430 to query whether a logic '1 - 0' transition has been received. The leader device 106 repeats blocks 428 and 430 until the logic '1 - 0' transition is received indicating completion of step C of the programming process and operation is completed. At this point, each of the configurable CAN devices on the S bus 110 are placed back into their normal mode for normal CAN system operation.

A controller area network (CAN) system including a serial conductor (S) bus, a CAN bus, at least one configurable CAN device, and a leader device. Each configurable CAN device is inserted on the S bus and includes media access control (MAC) circuitry and physical medium circuitry. The physical medium circuitry forwards test clocks from the CAN bus to clock internal latches when the CAN bus is in a common mode and interfaces the MAC circuitry for programming via the CAN bus when the CAN bus is in a differential mode. The leader device drives the S bus between first and second logic states, switches the CAN bus between the common and differential modes, generates test clocks on the CAN bus to place a selected configurable CAN device in programming mode, and programs the selected configurable CAN device via the CAN bus.

Aspects of the disclosure are defined in the accompanying claims. In a first aspect, there is provided a controller area network (CAN) system, comprising: a serial conductor bus having a first end and having a second end; a CAN bus; at least one configurable CAN device, each comprising: media access control (MAC) circuitry; and physical medium circuitry coupled to the CAN bus and to the MAC circuitry and comprising a plurality of latches interposed in series with the serial conductor bus, wherein the plurality of latches provides a mode signal indicative of either one of an idle mode and a programming mode; wherein the physical medium circuitry is configured to forward test clocks from the CAN bus to clock each of the plurality of latches when the CAN bus is in a common mode and to interface the MAC circuitry to program the MAC circuitry via the CAN bus when the CAN bus is in a differential mode; and a leader device coupled to the first end and the second end of the serial conductor bus and configured to drive the serial conductor bus between first and second logic states, to switch the CAN bus between the common mode and the differential mode, to generate test clocks on the CAN bus in the common mode to place a selected configurable CAN device in programming mode, and to program the selected configurable CAN device via the CAN bus in the differential mode.

In some embodiments, the CAN system further comprises: at least one insertion switch interposed between the first end and the second end of the serial conductor bus, wherein each insertion switch is closed for maintaining continuity and is opened for interrupting continuity of the serial conductor bus; wherein the plurality of latches comprises a first latch having a serial input for coupling to the serial conductor bus and comprises a last latch having a serial output coupled to the serial conductor bus; and wherein the physical medium circuitry comprises an activation output configured to open a corresponding one of the at least one insertion switch for coupling the serial conductor bus to the serial input for inserting the plurality of latches in series with the serial conductor bus.

In some embodiments, the leader device is configured to drive the serial conductor bus to the first logic state, to place the CAN bus in common mode and to toggle the CAN bus to generate a plurality of test clocks on the CAN bus to place each of the at least one configurable CAN device in idle mode, to drive the serial conductor bus to the second logic state for one test clock, and to drive the serial conductor bus back to the first logic state while generating at least one test clock on the CAN bus to select a configurable CAN device for programming.

In some embodiments, the physical medium circuitry further comprises: physical interface circuitry coupled to the CAN bus; a connection interface provided between the physical interface circuitry and the MAC circuitry; and wherein one of the plurality of latches has an output providing the mode signal to control the connection interface for selectively interfacing the physical interface circuitry with the MAC circuitry.

In some embodiments, the selected configurable CAN device is placed into programming mode when the mode signal is in the second logic state to control the connection interface to couple the physical interface circuitry to the MAC circuitry, and wherein the leader device is configured to switch the CAN bus into differential mode and program the MAC circuitry of the selected configurable CAN device via the CAN bus and the physical interface circuitry.

In some embodiments, the plurality of latches includes a last latch having an output coupled to the serial conductor bus and providing a control signal to the MAC circuitry, and wherein the selected configurable CAN device is in the idle mode when the mode signal is in the first logic state, is in the programming mode when the mode signal is in the second logic state while the control signal is in the first logic state, and is in a normal mode when the mode signal and the control signal are both in the second logic state.

In some embodiments, the physical medium circuitry further comprises a CAN mode sensor coupled to the CAN bus, wherein the CAN mode sensor is configured to forward each test clock asserted on the CAN bus when in the common mode to clock inputs of each of the plurality of latches, and to isolate the CAN bus from the plurality of latches when the CAN bus is in the differential mode.

In a second aspect, there is provided a configurable controller area network (CAN) device, comprising: media access control (MAC) circuitry; and physical medium circuitry coupled to the MAC circuitry and configured to couple to an external CAN bus and comprising a plurality of latches configured to couple in series with an external serial conductor bus, wherein the plurality of latches provides a mode signal indicative of either one of an idle mode and a programming mode; wherein the physical medium circuitry is configured to forward test clocks from the CAN bus to clock each of the plurality of latches when the CAN bus is in a common mode and to interface the MAC circuitry to program the at least one configurable CAN device via the CAN bus when the CAN bus is in a differential mode.

In some embodiments, the physical medium circuitry comprises an activation output configured to open an insertion switch interposed on the serial conductor bus for inserting the plurality of latches in series with the serial conductor bus.

In some embodiments, the physical medium circuitry further comprises: physical interface circuitry configured to coupled to the CAN bus; a connection interface provided between the physical interface circuitry and the MAC circuitry; and wherein one of the plurality of latches has an output providing the mode signal to control the connection interface for selectively interfacing the physical interface circuitry with the MAC circuitry.

In some embodiments, the programming mode occurs when the mode signal is in the second logic state to control the connection interface to couple the physical interface circuitry to the MAC circuitry, and wherein the MAC circuitry is programmed via the CAN bus placed in differential mode and the physical interface circuitry.

In some embodiments, the plurality of latches includes a last latch having an output configured to couple to the serial conductor bus and configured to provide a control signal to the MAC circuitry, and wherein the idle mode occurs when the mode signal is in the first logic state, wherein the programming mode occurs when the mode signal is in the second logic state while the control signal is in the first logic state, and wherein a normal mode occurs when the mode signal and the control signal are both in the second logic state.

In some embodiments, the configurable CAN device further comprises a CAN mode sensor configured to couple to the CAN bus, wherein the CAN mode sensor is configured to forward each test clock asserted on the CAN bus when in the common mode to clock inputs of each of the plurality of latches, and to isolate the CAN bus from the plurality of latches when the CAN bus is in the differential mode.

In a third aspect, there is provided method of in-system configuration of a controller area network (CAN) system that includes a CAN bus, comprising: providing a serial conductor bus with a first end and a second end; coupling at least one configurable CAN device to the serial conductor bus and to the CAN bus; driving the first end of the serial conductor bus between first and second logic states while generating test clocks on the CAN bus placed into a common mode for placing a selected configurable CAN device into a programming mode; placing the CAN bus in the differential mode; and programming the selected configurable CAN device via the CAN bus.

In some embodiments, the coupling at least one configurable CAN device comprising coupling a plurality of configurable CAN devices to the serial conductor bus and to the CAN bus; and repeating the driving the first end of the serial conductor bus between first and second logic states, placing the CAN bus in the differential mode and programming the selected configurable CAN device via the CAN bus for each of a selected number of the selected configurable CAN device via the CAN bus.

In some embodiments, the method further comprises driving the first end of the serial conductor bus to the second logic state while generating test clocks on the CAN bus placed into a common mode for placing each of the at least one configurable CAN device into a normal mode.

In some embodiments, the method further comprises after programming the selected configurable CAN device via the CAN bus, placing the CAN bus in the common mode, driving the first end of the serial conductor bus to the first logic state and generating test clocks on the CAN bus until the second end of the CAN bus is driven to the first logic state; and driving the first end of the serial conductor bus to the second logic state and generating test clocks on the CAN bus until the second end of the CAN bus is driven to the second logic state.

In some embodiments, the method further comprises: after coupling at least one configurable CAN device to the serial conductor bus, resetting the serial conductor bus and the at least one configurable CAN device so that each segment of the serial conductor bus is in the second logic state; the driving, comprising, placing the CAN bus in the common mode; and asserting the first logic state on the first end of the serial conductor bus and generating a plurality test clocks on the CAN bus until the second end of the serial conductor bus is driven to the first logic state so that each of the at least one configurable CAN device is in an idle mode; asserting the second logic state on the first end of the serial conductor bus and generating one test clock on the CAN bus; and asserting the first logic state on the first end of the serial conductor bus and generating at least one test clock on the CAN bus until the second logic state is latched into the selected configurable CAN device.

In some embodiments, the method further comprises after the programming the selected configurable CAN device via the CAN bus, driving the first end of the serial conductor bus to the second logic state while generating test clocks on the CAN bus placed into a common mode for placing each of the at least one configurable CAN device into a normal mode.

In some embodiments, the method further comprises: after programming the selected configurable CAN device via the CAN bus, placing the CAN bus in the common mode, driving the first end of the serial conductor bus to the first logic state and generating test clocks on the CAN bus until the second end of the CAN bus is driven to the first logic state; and driving the first end of the serial conductor bus to the second logic state and generating test clocks on the CAN bus until the second end of the CAN bus is driven to the second logic state.

Although the present invention has been described in connection with several embodiments, the invention is not intended to be limited to the specific forms set forth herein. On the contrary, it is intended to cover such alternatives, modifications, and equivalents as can be reasonably included within the scope of the invention as defined by the appended claims. For example, variations of positive circuitry or negative circuitry may be used in various embodiments in which the present invention is not limited to specific circuitry polarities, device types or voltage or error levels or the like. For example, circuitry states, such as circuitry low and circuitry high may be reversed depending upon whether the pin or signal is implemented in positive or negative circuitry or the like. In some cases, the circuitry state may be programmable in which the circuitry state may be reversed for a given circuitry function.

The terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles. Unless stated otherwise, terms such as "first" and "second" are used to arbitrarily distinguish between the elements such terms describe. Thus, these terms are not necessarily intended to indicate temporal or other prioritization of such elements.

## Claims

1. A controller area network (CAN) system, comprising:
a serial conductor bus having a first end and having a second end;
a CAN bus;
at least one configurable CAN device, each comprising:
media access control (MAC) circuitry; and
physical medium circuitry coupled to the CAN bus and to the MAC circuitry and comprising a plurality of latches interposed in series with the serial conductor bus, wherein the plurality of latches provides a mode signal indicative of either one of an idle mode and a programming mode;
wherein the physical medium circuitry is configured to forward test clocks from the CAN bus to clock each of the plurality of latches when the CAN bus is in a common mode and to interface the MAC circuitry to program the MAC circuitry via the CAN bus when the CAN bus is in a differential mode; and
a leader device coupled to the first end and the second end of the serial conductor bus and configured to drive the serial conductor bus between first and second logic states, to switch the CAN bus between the common mode and the differential mode, to generate test clocks on the CAN bus in the common mode to place a selected configurable CAN device in programming mode, and to program the selected configurable CAN device via the CAN bus in the differential mode.

2. The CAN system of claim 1, further comprising:
at least one insertion switch interposed between the first end and the second end of the serial conductor bus, wherein each insertion switch is closed for maintaining continuity and is opened for interrupting continuity of the serial conductor bus;
wherein the plurality of latches comprises a first latch having a serial input for coupling to the serial conductor bus and comprises a last latch having a serial output coupled to the serial conductor bus; and
wherein the physical medium circuitry comprises an activation output configured to open a corresponding one of the at least one insertion switch for coupling the serial conductor bus to the serial input for inserting the plurality of latches in series with the serial conductor bus.

3. The CAN system of claim 1 or 2, wherein the leader device is configured to drive the serial conductor bus to the first logic state, to place the CAN bus in common mode and to toggle the CAN bus to generate a plurality of test clocks on the CAN bus to place each of the at least one configurable CAN device in idle mode, to drive the serial conductor bus to the second logic state for one test clock, and to drive the serial conductor bus back to the first logic state while generating at least one test clock on the CAN bus to select a configurable CAN device for programming.

4. The CAN system of any preceding claim, wherein the physical medium circuitry further comprises:
physical interface circuitry coupled to the CAN bus;
a connection interface provided between the physical interface circuitry and the MAC circuitry; and
wherein one of the plurality of latches has an output providing the mode signal to control the connection interface for selectively interfacing the physical interface circuitry with the MAC circuitry.

5. The CAN system of claim 4, wherein the selected configurable CAN device is placed into programming mode when the mode signal is in the second logic state to control the connection interface to couple the physical interface circuitry to the MAC circuitry, and wherein the leader device is configured to switch the CAN bus into differential mode and program the MAC circuitry of the selected configurable CAN device via the CAN bus and the physical interface circuitry.

6. The CAN system of claim 5, wherein the plurality of latches includes a last latch having an output coupled to the serial conductor bus and providing a control signal to the MAC circuitry, and wherein the selected configurable CAN device is in the idle mode when the mode signal is in the first logic state, is in the programming mode when the mode signal is in the second logic state while the control signal is in the first logic state, and is in a normal mode when the mode signal and the control signal are both in the second logic state.

7. The CAN system of any preceding claim, wherein the physical medium circuitry further comprises a CAN mode sensor coupled to the CAN bus, wherein the CAN mode sensor is configured to forward each test clock asserted on the CAN bus when in the common mode to clock inputs of each of the plurality of latches, and to isolate the CAN bus from the plurality of latches when the CAN bus is in the differential mode.

8. A method of in-system configuration of a controller area network (CAN) system that includes a CAN bus, comprising:
providing a serial conductor bus with a first end and a second end;
coupling at least one configurable CAN device to the serial conductor bus and to the CAN bus;
driving the first end of the serial conductor bus between first and second logic states while generating test clocks on the CAN bus placed into a common mode for placing a selected configurable CAN device into a programming mode;
placing the CAN bus in the differential mode; and
programming the selected configurable CAN device via the CAN bus.

9. The method of claim 8, further comprising:
the coupling at least one configurable CAN device comprising coupling a plurality of configurable CAN devices to the serial conductor bus and to the CAN bus; and
repeating the driving the first end of the serial conductor bus between first and second logic states, placing the CAN bus in the differential mode and programming the selected configurable CAN device via the CAN bus for each of a selected number of the selected configurable CAN device via the CAN bus.

10. The method of claim 9, further comprising driving the first end of the serial conductor bus to the second logic state while generating test clocks on the CAN bus placed into a common mode for placing each of the at least one configurable CAN device into a normal mode.

11. The method of claim 9 or 10, further comprising:
after programming the selected configurable CAN device via the CAN bus, placing the CAN bus in the common mode, driving the first end of the serial conductor bus to the first logic state and generating test clocks on the CAN bus until the second end of the CAN bus is driven to the first logic state; and
driving the first end of the serial conductor bus to the second logic state and generating test clocks on the CAN bus until the second end of the CAN bus is driven to the second logic state.

12. The method of any of claims 9 to 11, further comprising:
after coupling at least one configurable CAN device to the serial conductor bus, resetting the serial conductor bus and the at least one configurable CAN device so that each segment of the serial conductor bus is in the second logic state;
the driving, comprising,
placing the CAN bus in the common mode; and
asserting the first logic state on the first end of the serial conductor bus and generating a plurality test clocks on the CAN bus until the second end of the serial conductor bus is driven to the first logic state so that each of the at least one configurable CAN device is in an idle mode;
asserting the second logic state on the first end of the serial conductor bus and generating one test clock on the CAN bus; and
asserting the first logic state on the first end of the serial conductor bus and generating at least one test clock on the CAN bus until the second logic state is latched into the selected configurable CAN device.

13. The method of claim 12, after the programming the selected configurable CAN device via the CAN bus, driving the first end of the serial conductor bus to the second logic state while generating test clocks on the CAN bus placed into a common mode for placing each of the at least one configurable CAN device into a normal mode.

14. The method of claim 12 or 13, further comprising:
after programming the selected configurable CAN device via the CAN bus, placing the CAN bus in the common mode, driving the first end of the serial conductor bus to the first logic state and generating test clocks on the CAN bus until the second end of the CAN bus is driven to the first logic state; and
driving the first end of the serial conductor bus to the second logic state and generating test clocks on the CAN bus until the second end of the CAN bus is driven to the second logic state.
